# DEMANDE DE BREVET EUROPEEN

(11) **EP 1 018 859 A1**
(43) Date de publication de la demande: **12.07.2000**
(21) Numéro de dépôt: 00400029.5
(22) Date de dépôt: 07.01.2000
(51) Int. Cl.: H05K 9/00, H05K 7/14

(54) **Ensemble de circuit haute fréquence avec blindage électromagnétique**

(30) Priorité: 08.01.1999 FR 9900134
(71) Demandeur: SAGEM SA, 75116 Paris (FR)
(72) Inventeur: Huriau, Alain, 59910 Bondues (FR); Desreumaux, Bertrand, 59260 Hellemmes (FR)
(74) Mandataire: Bloch, Gérard

(57) **Abrégé**

L'ensemble comprend:
- un circuit haute fréquence monté sur au moins une platine (30),
- un corps (36) support de la platine présentant des surfaces d'appui (42a) destinées à coopérer avec une face (32a) de la platine pour réaliser au sein de celle-ci des compartiments de blindage vis-à-vis du rayonnement haute fréquence et
- une plaque conductrice rigide (50) formant écran pour la platine (30), montée contre l'autre face de la platine de manière à plaquer celle-ci contre les surfaces d'appui.

La plaque (50) peut être fixée par des éléments de serrage (66) situés en des points extérieurs à la platine (32). Elle peut être réalisée en un métal massif, éventuellement recouverte sur l'une ou sur chaque surface d'une couche de métal de haute conductivité.

## Description

La présente invention concerne un ensemble de circuit haute fréquence avec blindage électromagnétique. L'ensemble peut éventuellement incorporer une antenne pour former un émetteur et/ou un récepteur haute fréquence intégré, par exemple un répéteur destiné aux téléphones mobiles dans un réseau de téléphonie cellulaire.

En raison des hautes fréquences utilisées, les éléments de circuit de l'ensemble doivent être protégés non seulement vis-à-vis des perturbations électromagnétiques extérieures, mais aussi vis-à-vis des différentes sections au sein du circuit. En effet, chaque section qui constitue un étage actif par exemple un étage d'amplification, est une source de rayonnement susceptible de perturber des sections voisines tout en étant elle-même sensible aux rayonnements de ces dernières.

Aussi, il convient de former un blindage sous forme de cage de Faraday autour de chaque section du circuit de l'ensemble haute fréquence devant être isolée.

Par ailleurs, lorsque l'ensemble incorpore une antenne, un blindage doit également être prévu entre celle-ci et le circuit pour éviter des perturbations mutuelles.

Le problème de blindage devient particulièrement aigu lorsque les fréquences mises en oeuvre atteignent des valeurs très élevées, de l'ordre de plusieurs centaines de MHz, voire quelques GHz. Or, on utilise maintenant de telles fréquences très largement, notamment en téléphonie cellulaire qui exploite des bandes de fréquences autour de 900 MHz ou 1800 MHz.

A ces fréquences, on ne peut tolérer pour le blindage entre les différentes sections du circuit aucune ouverture au-delà d'une fraction de millimètre afin d'assurer une étanchéité électromagnétique adéquate. Le blindage pour chaque section doit ainsi prendre la forme d'un caisson conducteur totalement fermé autour de la section du circuit à isoler. Dans la pratique, le circuit se présente sous la forme d'une platine qui comporte souvent son propre blindage, mais seulement au niveau de sa surface. Ce blindage se présente par exemple sous la forme de métallisations reliées à la masse selon les sections à isoler. Le caisson de blindage est alors fixé sur la platine en contact avec les métallisations.

L'interface mécanique entre le caisson de blindage et le circuit est particulièrement délicat, car tout espace parasite entre ces deux éléments est source de fuite de rayonnement électromagnétique susceptible de perturber le circuit.

Dans l'état de la technique, les caissons de blindage sont généralement fixés sur le circuit par vissage. A cet effet, on prévoit une série de trous de vissage rapprochés sur tout le pourtour du caisson de blindage, généralement dans la tranche destinée à être en contact avec le circuit. Lorsque les fréquences utilisées atteignent les ordres de grandeur précités, il s'avère nécessaire de rapprocher les points de vissage tous les deux centimètres, voire tous les centimètres, pour assurer un plaquage suffisamment étanche des caissons contre le circuit.

Une telle densité de points de vissage est pénalisante tant du point de vue des coûts de fabrication que de la facilité de la maintenance du circuit. Par ailleurs, la qualité de l'étanchéité au rayonnement obtenue par cette technique est très sensible à la force de serrage des vis, ce qui engendre des problèmes de fiabilité et de maintien des caractéristiques dans le temps.

D'autre part, lorsque le circuit haute fréquence comprend un émetteur, il doit respecter des normes d'émission sévères, notamment pour ce qui concerne la bande passante du signal émis. En effet, les canaux de communications haute fréquence sont définis de manière précise et se succèdent sur des plages de fréquences continues qui peuvent être partagées par plusieurs opérateurs indépendants. Dans ce cas, un émetteur fonctionnant sur des canaux alloués à un opérateur ne doit émettre qu'aux fréquences de ces canaux, et pas sur les fréquences de canaux voisins pouvant être exploités par un autre opérateur. Il convient donc de conférer aux émetteurs haute fréquence une bande passante d'émission ayant des flancs très raides.

Afin de répondre à ces prérogatives, les émetteurs utilisent des circuits complexes, faisant intervenir notamment des étages de filtrage du signal basés sur des filtres à onde de surface (FOS), aussi connus sous le terme de filtres SAW.

Par ailleurs, on cherche à réduire autant que possible les dimensions des émetteurs haute fréquence afin de pouvoir les placer plus facilement aux endroits propices, par exemple dans des zones d'ombre d'un espace de téléphonie cellulaire.

Pour résoudre ce problème, l'invention propose un ensemble de circuit haute fréquence avec blindage électromagnétique, caractérisé par le fait qu'il comprend:
- un circuit haute fréquence monté sur au moins une platine,
- un corps support de la platine présentant des surfaces d'appui destinées à coopérer avec une face de la platine pour réaliser au sein de celle-ci des compartiments de blindage vis-à-vis du rayonnement haute fréquence et
- une plaque conductrice rigide formant écran, montée contre l'autre face de la platine de manière à plaquer celle-ci contre les surfaces d'appui.

On remarque que la plaque selon la présente invention a une double fonction : d'une part elle constitue un écran au rayonnement électromagnétique entre l'extérieur et le circuit, et d'autre part elle forme une surface de transmission d'effort mécanique pour forcer la platine contre les surfaces d'appui de manière à assurer l'étanchéité électromagnétique des compartiments du circuit.

La force exercée par la plaque est sensiblement uniforme sur tous les points de la platine, et notamment le long des surfaces d'appui. De la sorte, il est possible d'assurer un contact sans discontinuités de la platine sur toutes les surfaces d'appui.

Etant rigide, la plaque peut être fixée avec seulement quelques éléments de serrage, d'où une facilité de montage et de démontage du circuit vis-à-vis de son support et de ses compartiments de blindage. Qui plus est, ces éléments de serrage peuvent être avantageusement situés à des points de la plaque en dehors de la platine, afin de ne pas gêner son fonctionnement.

La plaque conductrice peut être réalisée en un métal massif et, éventuellement, être recouverte sur l'une ou sur chaque face d'une couche de métal de haute conductivité. Il est cependant possible d'envisager une structure composite pour la plaque. Dans ce cas, la plaque peut comporter une strate en un matériau non conducteur.

L'ensemble de circuit haute fréquence de l'invention peut aussi incorporer une antenne d'émission et/ou de réception, par exemple une antenne plane omnidirectionnelle. Dans ce cas, on peut prévoir de monter l'antenne en regard de la face extérieure de la plaque afin que celle-ci constitue un écran entre le circuit et l'antenne. Il est aussi possible de monter l'antenne de sorte que la plaque puisse servir de réflecteur, notamment en mode émission.

Dans un mode de réalisation avantageux de l'invention, la plaque et le corps support constituent pour la platine un caisson pratiquement hermétique au rayonnement haute fréquence.

Les surfaces d'appui du support peuvent être constituées par les sommets d'éléments de paroi conductrices qui s'étendent depuis le fond du corps support, ce fond étant également conducteur. Dans ce cas, les compartiments de blindage peuvent former une partie intégrante du corps support. Il en résulte une bonne tenue mécanique des compartiments. Par ailleurs, tous les sommets précités se trouvant sur un même plan, leur usinage peut être aisément réalisé avec précision.

Avantageusement, la plaque selon l'invention assure également une troisième fonction de dissipation de la chaleur engendrée par le circuit, en étant mise en contact thermique avec la platine, de manière à agir comme radiateur pour le circuit.

Il est possible de prévoir un revêtement conducteur sur la face de la platine qui est tournée vers la plaque, le revêtement étant relié électriquement aux surfaces d'appui. Ce revêtement assure une fonction d'écran électromagnétique supplémentaire vis-à-vis de la plaque, permettant alors de prévoir une ou plusieurs ouvertures au niveau de celle-ci. De telles ouvertures peuvent être utiles pour permettre l'accès, du côté de la plaque, à certains points du circuit, par exemple à des connexions externes ou à des contacts de test. Elles peuvent aussi permettre de placer des composants sur la face de la platine tournée vers la plaque, notamment des boîtiers de filtres à onde de surface. Une telle disposition permet d'accroître la compacité de l'ensemble.

Lorsque l'ensemble incorpore une antenne, la plaque peut servir également de moyen de support pour l'antenne.

Cependant, il est aussi possible de prévoir le support de l'antenne incorporé au niveau de la platine.

Avantageusement, sensiblement tous les composants du circuit sont implantés sur la face de la platine tournée vers le corps support.

L'invention permet de réaliser un ensemble haute fréquence avec blindage électromagnétique ayant des dimensions très réduites, surtout lorsque l'ensemble incorpore une antenne plane. Elle peut notamment trouver application en tant que répéteur compact pour les télécommunications. Par exemple, un tel répéteur peut être installé de façon discrète dans un intérieur (habitation, local public, véhicule, etc.) pour effacer des zones d'ombre dans un espace de couverture de téléphonie cellulaire.

Dans ce cas, le circuit haute fréquence comportera une antenne ou une liaison avec une antenne dans la zone d'ombre, une interface entrée/sortie pour connexion à une antenne extérieure à la zone d'ombre et des moyens de retransmission des signaux entre l'interface entrée/sortie et l'antenne incorporée ou disposée dans la zone d'ombre.

L'invention sera mieux comprise à l'aide de la description suivante d'un mode de réalisation préféré, donné purement à titre d'exemple, en référence aux dessins annexés, sur lesquels :
- la figure 1 représente schématiquement un espace élémentaire de couverture de téléphonie cellulaire présentant une zone d'ombre;
- la figure 2 est un schéma simplifié d'un répéteur utilisé dans la zone d'ombre de la figure 1 ;
- la figure 3a représente graphiquement un exemple d'allocation de canaux pour les liaisons montantes et descendantes sur des plages haute fréquence;
- la figure 3b est une courbe d'amplification d'un amplificateur du répéteur de la figure 2 utilisé pour les liaisons montantes;
- la figure 3c est une courbe d'amplification d'un amplificateur du répéteur de la figure 2 utilisé pour les liaisons descendantes;
- la figure 4 est une vue en plan de la platine du répéteur de la figure 2, conformément à un mode de réalisation de la présente invention, montrant les pistes conductrices sur la face avant destinées au blindage;
- la figure 5 est une vue en coupe de l'ensemble de circuit haute fréquence conformément à un mode de réalisation de l'invention, suivant l'axe V-V de la figure 4;
- la figure 6 est une vue en plan sur l'ouverture du bâti de support du répéteur de la figure 5, fermée par une plaque conductrice rigide et
- la figure 7 est une vue générale d'un répéteur de la figure 5.

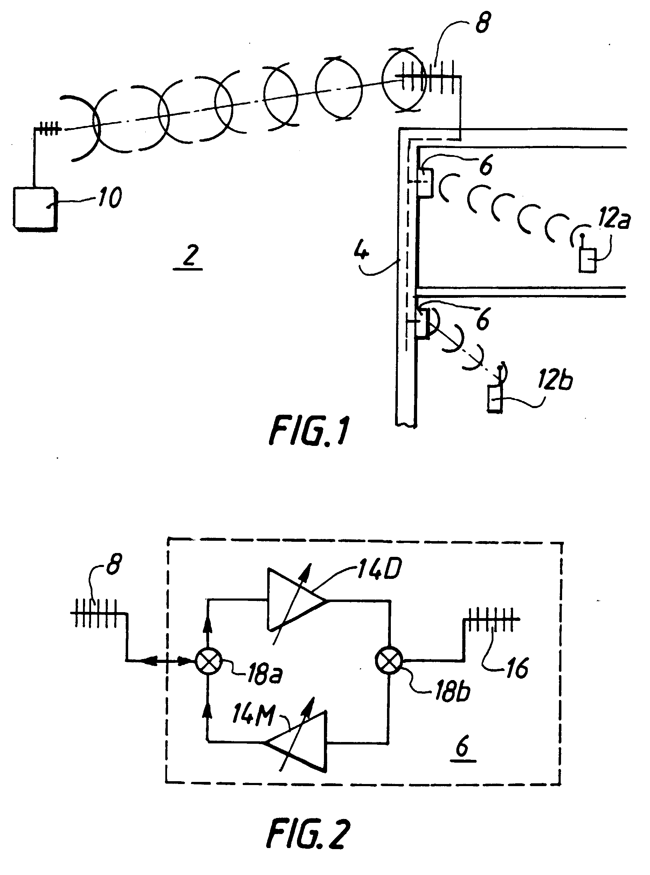

La figure 1 représente schématiquement un espace élémentaire 2 de couverture de téléphonie cellulaire qui comprend un bâtiment 4 dans lequel sont installés des répéteurs 6. Le rôle des répéteurs 6 est d'assurer un lien de communication entre l'intérieur et l'extérieur du bâtiment 4. En effet, un bâtiment, surtout s'il comporte une armature métallique, tend à atténuer fortement les signaux utilisés en téléphonie cellulaire, qui ont une fréquence de l'ordre de 1 GHz.

A cette fin, chaque répéteur 6 est câblé à une antenne 8 à l'extérieure du bâtiment, qui assure une liaison hertzienne bidirectionnelle avec une station fixe 10. Le répéteur 6 comporte sa propre antenne et des circuits d'amplification de signaux entre celle-ci et l'antenne extérieure 8. Lorsqu'un téléphone mobile 12a dans le bâtiment 4 est en mode émission, le répéteur 6 assure la liaison montante, c'est-à-dire que les signaux de ce téléphone sont captés par l'antenne du répéteur, où ils sont traités et amplifiés, puis sont envoyés sur l'antenne extérieure 8 pour transmission vers la station de base 10. A l'inverse, lorsque qu'un téléphone mobile 12b est en mode réception, le répéteur 6 assure la liaison descendante, c'est-à-dire que les signaux reçus sur l'antenne extérieure 8 depuis la station de base 10 sont transmis vers le répéteur 6 où ils sont traités et amplifiés avant d'être ré-émis sur l'antenne du répéteur.

Ainsi, les répéteurs 6 assurent à la fois les liaisons montantes et les liaisons descendantes.

La figure 2 représente schématiquement et de manière très simplifiée les blocs fonctionnels d'un répéteur 6. Celui-ci comporte deux amplificateurs à gain ajustable 14D et 14M qui assurent l'amplification des signaux pour la liaison descendante et la liaison montante, respectivement. Ces amplificateurs 14D et 14M sont branchés entre l'antenne extérieure 8 et l'antenne interne 16 du répéteur 6 via des coupleurs d'entrées/sorties respectifs 18a, 18b. L'amplificateur 14D de la liaison descendante a son entrée reliée à l'antenne extérieure 8 par le coupleur 18a et sa sortie reliée à l'antenne interne 16 par le coupleur 18b. L'amplificateur 14M de la liaison montante a son entrée reliée à l'antenne interne 16 par le coupleur 18b et sa sortie reliée à l'antenne extérieure 8 par le coupleur 18a.

Les fréquences utilisées pour les liaisons montantes et les liaisons descendantes sont situées sur des plages distinctes, fixées par des normes de télécommunications.

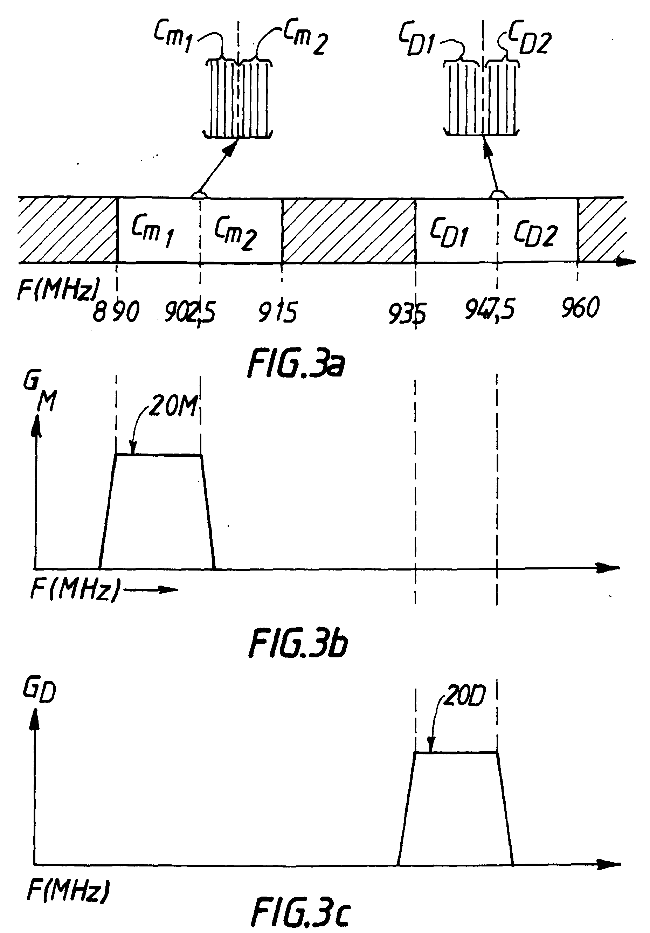

La figure 3a montre, à titre d'exemple, la répartition des fréquences exploitables pour les liaisons montantes et descendantes conformément à la norme de téléphonie cellulaire GSM 900 Mhz actuellement en vigueur. Les plages de fréquences disponibles pour les liaisons montantes et descendantes sont respectivement de 890 à 915 Mhz et de 935 à 960 MHz. Chacune de ces plages est divisée en un ensemble de canaux de transmission ou de réception, à raison d'un canal tous les 200 kHz. Un téléphone mobile en communication bidirectionnelle occupe un canal dans chacune des deux plages de fréquences dédiées respectivement aux liaisons montantes et descendantes.

Ces plages de fréquences peuvent être partagées ente plusieurs opérateurs indépendants. Dans ce cas, chaque opérateur dispose de ses propres groupes de canaux situés sur une portion des plages de fréquences qui lui est attribuée. Dans l'exemple de la figure 3a, les plages de fréquences sont partagées équitablement entre deux opérateurs. Un premier opérateur dispose de canaux C_{M1} pour les liaisons montantes, situés dans la bande de fréquences ente 890 et 902,5 MHz et de canaux C_{D1} pour les liaisons descendantes, situés dans la bande de fréquences entre 935 et 947,5 MHz. Le second opérateur dispose de canaux C_{M2} pour les liaisons montantes, situées dans la bande de fréquences entre 902,5 et 915 MHz et de canaux C_{D2} pour les liaisons descendantes, situés dans la bande de fréquences entre 947,5 et 960 MHz.

Dans le cas de plages de fréquences partagées, il est important que les répéteurs 6 fonctionnant avec un opérateur n'amplifient et ne ré-émettent que sur les portions des fréquences qui lui sont attribuées.

Les figures 3b et 3c représentent respectivement les caractéristiques de gain des amplificateurs 14M et 14D d'un répéteur 6 fonctionnant sur les fréquences allouées au premier opérateur. On remarque que le gain G_{M} de l'amplificateur 14M pour les liaisons montantes et le gain G_{D} de l'amplificateur 14D pour les liaisons descendantes présentent un plateau respectif 20M et 20D sur leurs portions de fréquences réservées, et tombent très rapidement à zéro en dehors de ces portions de fréquences.

Ces caractéristiques de gain font appel à des circuits de grande précision qui comportent de nombreux étages travaillant à différentes fréquences ou à différents niveaux d'amplification, y compris des étages de filtrage basés sur des filtres à onde de surface (FOS).

Comme expliqué précédemment, il est nécessaire que chaque étage soit isolé des étages voisins du point de vue du rayonnement électromagnétique.

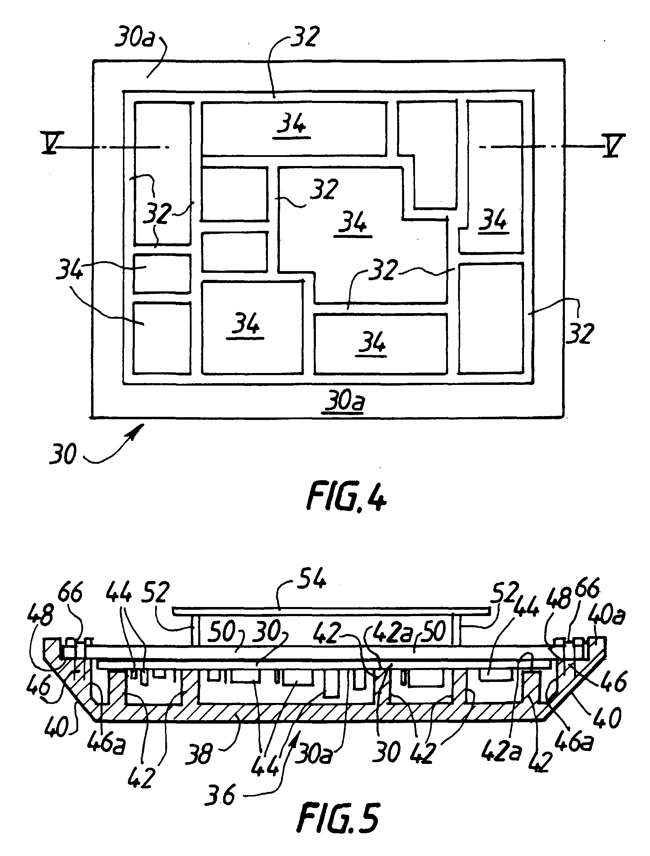

La figure 4 est une vue en plan de la face 30a (désormais appelée face avant) d'une platine 30 sur laquelle sont implantés les composants formant le circuit haute fréquence du répéteur 6. La platine 30 est un élément plan en matière rigide et isolante.

La face avant 30a comporte un réseau de pistes conductrices 32 formées par des métallisations en surface. Ces pistes conductrices 32 encerclent des aires 34, chaque aire étant destiné à contenir un étage respectif du circuit haute fréquence devant être isolé des étages voisins.

La face arrière (non représentée) de la platine 30 est recouverte d'une métallisation conductrice occupant toute sa surface. Cette métallisation est destinée à être reliée à la masse pour former un écran électromagnétique. La platine 30 comporte des lignes de fines perforations rapprochées, tout le long des pistes conductrices 32. Ces perforations sont métallisées sur leurs bords sur toute l'épaisseur de la platine de manière constituer des vias d'interconnexion entre les pistes conductrices 32 et la métallisation conductrice sur la face arrière de la platine.

La figure 5 est une vue en coupe longitudinale, suivant l'axe V-V de la figure 4, de la platine 30 montée sur son bâti, ou corps support, 36. Ce bâti a la forme générale d'une coupelle rectangulaire ayant une base plane 38, formant fond conducteur, et des parois latérales 40 évasées vers l'ouverture. Toutefois, une partie 40a des parois latérales 40 à proximité de l'ouverture est perpendiculaire à la base 38. Le bâti 36 est réalisé d'une seule pièce en un matériau conducteur, par exemple de la fonte d'aluminium.

Un réseau de parois conductrices 42, agencées selon la même topographie que le réseau de pistes conductrices 32 de la platine 30, est intégré à la surface interne de la base 38. Ces parois 42 sont perpendiculaires à la base 38 et ont des sommets plans 42a destinés à former des surfaces d'appui pour la platine 30, prenant contact avec les pistes conductrices 32 de celle-ci.

Dans l'exemple représenté, les divers composants 44 qui constituent le circuit haute fréquence sont implantés sur la face avant 30a de la platine 30. La platine 30 est positionnée dans le bâti 36 avec sa face avant 30a tournée vers la base 38. Elle est bloquée latéralement en position par des butées constituées par la face verticale 46a d'un épaulement 46 formé sur tout le pourtour de la face intérieure des bords évasés 40. L'épaulement 46 présente une surface horizontale formant un palier 48 qui encadre complètement la platine 30. Ce palier 48 est situé sur le même plan horizontal que la face arrière de la platine 30 lorsque celle-ci est posée sur les sommets 42a des parois 42, ou éventuellement sur un plan horizontal légèrement plus rapproché de la base du bâti 36. Il est par ailleurs situé sensiblement au niveau à partir duquel s'étend la partie verticale 40a des parois 40.

L'épaulement 46 comporte des trous de vissage traversants pratiqués à intervalle régulier le long du palier 48, y compris au niveau des coins.

Une plaque plane 50, rigide et relativement épaisse, repose sur le palier 48 de l'épaulement 46 de manière à fermer l'ouverture du bâti 36. La plaque 50 est réalisée en un matériau conducteur tel que de l'aluminium pour former un écran électromagnétique entre la platine 30 et l'espace à l'extérieur de l'ouverture.

La plaque 50 comporte des trous traversants alignés avec les trous de vissage du palier 48 de manière à pouvoir être vissée sur celui-ci. Lorsque la plaque 50 est vissée sur le palier 48, sa face inférieure agit contre la platine 30 et force la face avant 30a de celle-ci contre les sommets 42a des parois 42. Ainsi, la plaque 50 sert également de surface de transmission d'effort mécanique, agissant uniformément sur toute la surface de la platine 32. Il s'établit alors un contact électrique sans discontinuités entre les pistes conductrices 32 et les sommets 42a des parois 42.

De la sorte, un blindage électromagnétique sous forme de cage de Faraday parfaitement étanche est créé entre les différentes sections 34 du circuit. Au niveau du bâti, un blindage enveloppant est réalisé autour de chaque section 34 par les parois conductrices 42 qui entourent la section et le fond conducteur 38 du bâti 36 auquel ces parois sont reliées. Au niveau de la platine 32, le blindage est complété en surface par la métallisation sur la face arrière de la platine et aussi par la plaque conductrice 50.

Dans l'exemple représenté, la plaque conductrice 50 présente sur sa face extérieure des colonnettes 52 pour supporter une antenne omnidirectionnelle plane 54. Ainsi, la plaque conductrice sert de plan de réflexion pour l'antenne 54. L'antenne est maintenue dans un plan parallèle à la plaque 50, à une distance calculée afin de minimiser les pertes.

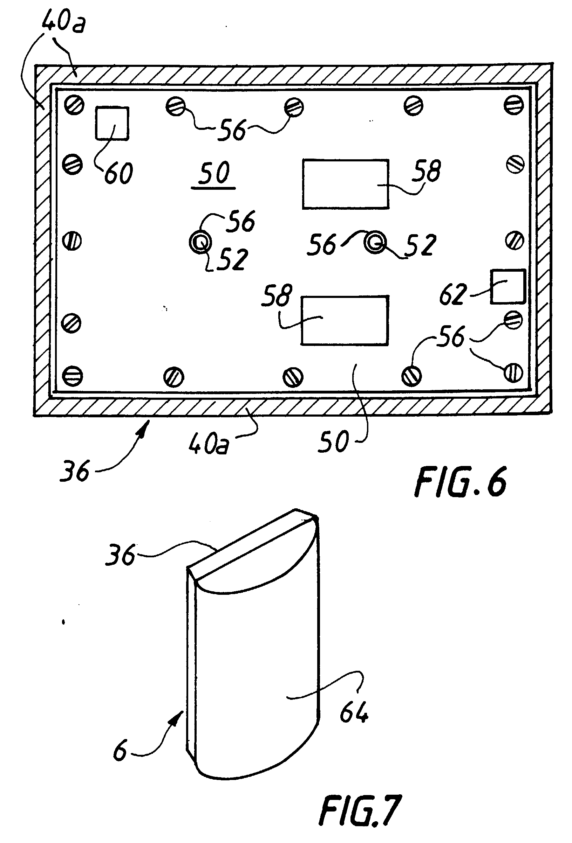

Les colonnettes de support 52 sont ancrées à la platine 30 et passent à travers des trous traversants 56 pratiquées dans la plaque conductrice 50 (figure 6). Toutefois, il est possible d'envisager des points d'ancrage pour une fixation d'antenne au niveau de la plaque 50.

On remarquera que l'épaisseur de la plaque 50 est contenue dans la hauteur des portions 40a des parois 40 formant le bord du bâti 36. De la sorte, l'ensemble constitué par le bâti 36 et la plaque 50 forme une cage de Faraday étanche entre la platine 30 et son environnement extérieur.

Par ailleurs, la plaque 50 constitue un radiateur efficace pour répartir et évacuer la chaleur engendrée par le circuit, grâce à sa masse relativement importante, son contact thermique sur quasiment toute la surface de la platine 30 et sa face ouverte sur l'extérieur.

La figure 6 est une vue en plan montrant la face supérieure de la plaque conductrice 50 lorsque celle-ci est montée sur le bâti 36. Dans cet exemple, la plaque 50 est fixée par des vis 66 sur les bords et aux coins. La rigidité de la plaque est telle qu'il est inutile de prévoir des points de vissage ou d'autres moyens de fixation à l'aplomb de la platine 30.

Tout en formant une surface sensiblement continue, la plaque peut néanmoins comporter un certain nombre d'ouvertures. Dans l'exemple représenté, deux ouvertures rectangulaires 58 sont pratiquées dans la plaque 50 pour autoriser l'implantation de deux boîtiers de filtre à onde de surface sur la face supérieure de la platine 30. On notera que ces boîtiers intègrent leur propre blindage métallique relié à la masse et n'occasionnent de ce fait aucune dégradation sensible de l'effet d'écran électromagnétique sur la surface de la plaque.

La plaque 50 comporte en outre une ouverture 60 permettant l'accès à des connexions internes du circuit, par exemple des points de test ou des points de réglage, et une ouverture 62 permettant de relier le circuit haute fréquence à l'antenne extérieure 8 (figures 1 et 2).

On remarquera que dans l'exemple considéré, les composants 44 sont implantés sur une seule face 30a de la platine, hormis les boîtiers de filtres FOS qui ne nécessitent pas de blindage additionnel. Par ailleurs, le fait d'intégrer les éléments de blindage 42, 38 au bâti support 36 permet d'obtenir pour ces éléments une structure rigide et des cotes contrôlées avec précision.

La figure 7 montre l'aspect général du répéteur 6. Le bâti 36, qui forme le corps de support, est associé à une coque recouvrante 64 en matière isolante qui protège le circuit haute fréquence de l'environnement. La coque 64 est bombée et constitue un radôme pour l'antenne plane omnidirectionnelle 54.

L'exemple qui vient d'être décrit concerne sur un répéteur destiné à la téléphonie mobile par réseau cellulaire. Toutefois, le répéteur peut également convenir à d'autres applications, par exemple pour relayer des transmissions de données informatiques, des commandes d'appareils, des signaux vidéo ou audio sur porteuses haute fréquence, ou pour la téléphonie sans fil sur des canaux analogiques ou numériques, tels que ceux utilisant la norme DECT.

Enfin, il sera clair que l'invention n'est nullement limité à un répéteur, et peut être mise en oeuvre avantageusement pour tout circuit haute fréquence nécessitant un blindage.

## Revendications

1. Ensemble de circuit haute fréquence (6) avec blindage électromagnétique, caractérisé par le fait qu'il comprend:
- un circuit haute fréquence monté sur au moins une platine (30),
- un corps (36) support de la platine présentant des surfaces d'appui (42a) destinées à coopérer avec une face (30a) de la platine pour réaliser au sein de celle-ci des compartiments de blindage vis-à-vis du rayonnement haute fréquence et
- une plaque conductrice rigide (50) formant écran, montée contre l'autre face de la platine (30) de manière à plaquer celle-ci contre les surfaces d'appui.

2. Ensemble selon la revendication 1, caractérisé par le fait que la plaque (50) est fixée par des éléments de serrage (66) situés en des points extérieurs à la platine (30).

3. Ensemble selon la revendication 1 ou 2, caractérisé par le fait que la plaque (50) est réalisée en un métal massif; éventuellement recouverte sur l'une ou sur chaque face d'une couche de métal de haute conductivité.

4. Ensemble selon l'une des revendications 1 à 3, caractérisé par le fait qu'il incorpore une antenne d'émission et/ou de réception (54).

5. Ensemble selon la revendication 4, caractérisé par le fait que l'antenne (54) est montée en regard de la face extérieure de la plaque (50) afin que celle-ci constitue un écran entre la platine (30) et l'antenne.

6. Ensemble selon l'une quelconque des revendications 1 à 5, caractérisé par le fait que la plaque (50) et le corps support (36) constituent pour la platine (30) un caisson sensiblement hermétique aux rayonnements haute fréquence.

7. Ensemble selon l'une quelconque des revendications 1 à 6, caractérisé par le fait que les surfaces d'appui sont constituées par les sommets (42a) d'éléments de paroi conductrices (42) qui s'étendent depuis le fond du corps support (36), ce fond étant également conducteur.

8. Ensemble selon l'une quelconque des revendications 1 à 7, caractérisé par le fait que la plaque (50) est en contact thermique avec la platine (30) de manière à agir ainsi comme radiateur pour le circuit.

9. Ensemble selon l'une quelconque des revendications 1 à 8, caractérisé par le fait la surface de la platine (30) en contact avec la plaque (50) comporte un revêtement conducteur relié électriquement aux surfaces d'appui (42a).

10. Ensemble selon l'une quelconque des revendications 1 à 9, caractérisé par le fait que sensiblement tous les composants (44) du circuit sont implantés sur la face (30a) de la platine (30) tournée vers le corps support (36).

11. Ensemble selon l'une quelconque des revendications 1 à 10, caractérisé par le fait que la plaque (50) présente au moins une ouverture (58, 60, 62) autorisant l'accès à un point ou à un composant du circuit.

12. Répéteur compact (6) pour couvrir des zones d'ombre dans un espace de télécommunication de téléphonie cellulaire (2), comprenant un ensemble haute fréquence selon l'une quelconque des revendications 1 à 11, ledit circuit haute fréquence comportant une interface entrée/sortie pour connexion à une antenne (8) extérieure à la zone d'ombre et des moyens de retransmission des signaux entre l'interface entrée/sortie et une antenne (16) dans la zone d'ombre.
